# EUROPÄISCHE PATENTSCHRIFT

(11) **EP 2 614 536 B1**
(45) Veröffentlichungstag und Bekanntmachung des Hinweises auf die Patenterteilung: **27.01.2016**
(21) Anmeldenummer: 11748627.4
(22) Anmeldetag: 16.08.2011
(51) Int. Cl.: H01L 33/40, H01L 33/44, H01L 33/46

(54) **DÜNNSCHICHTVERKAPSELUNG, OPTOELEKTRONISCHER HALBLEITERKÖRPER MIT EINER DÜNNSCHICHTVERKAPSELUNG UND VERFAHREN ZUR HERSTELLUNG EINER DÜNNSCHICHTVERKAPSELUNG**
THIN-FILM ENCAPSULATION, OPTOELECTRONIC SEMICONDUCTOR BODY COMPRISING A THIN-FILM ENCAPSULATION AND METHOD FOR PRODUCING A THIN-FILM ENCAPSULATION
ENCAPSULATION EN COUCHES MINCES, CORPS SEMI-CONDUCTEUR OPTOÉLECTRONIQUE MUNI D'UNE ENCAPSULATION EN COUCHES MINCES ET PROCÉDÉ POUR LA FABRICATION D'UNE ENCAPSULATION EN COUCHES MINCES

(30) Priorität: 08.09.2010 DE 102010044738
(43) Veröffentlichungstag der Anmeldung: 17.07.2013
(73) Patentinhaber: OSRAM Opto Semiconductors GmbH, 93055 Regensburg (DE)
(72) Erfinder: EBERHARD, Franz, 93059 Regensburg (DE); TAEGER, Sebastian, 93055 Regensburg (DE); PERZLMAIER, Korbinian, 93051 Regensburg (DE)
(74) Vertreter: Epping - Hermann - Fischer
(86) Internationale Anmeldenummer: PCT/EP2011/064098
(87) Internationale Veröffentlichungsnummer: WO 2012/031858

(56) Entgegenhaltungen:
- EP-A2- 1 646 092
- DE-A1-102005 029 272
- US-A1- 2003 102 484
- US-A1- 2005 001 222
- US-A1- 2008 305 631

## Beschreibung

Es werden eine Dünnschichtverkapselung, ein optoelektronischer Halbleiterkörper mit einer Dünnschichtverkapselung und ein Verfahren zur Herstellung einer Dünnschichtverkapselung angegeben.

Eine Dünnfilmverkapselung ist beispielsweise in den folgenden Druckschriften beschrieben: EP 1646092, US 2008/0305631, US 2003/0102484, US 2005/0001222, DE 102005029272.

Aufgabe der vorliegenden Erfindung ist es, eine Dünnschichtverkapselung, insbesondere für einen optoelektronischen Halbleiterkörper anzugeben, die dazu geeignet ist, Oberflächen mit topographischen Unebenheiten gut zu verkapseln.

Weiterhin soll ein optoelektronischer Halbleiterkörper mit einer solchen Dünnschichtverkapselung sowie ein Verfahren zur Herstellung einer solchen Dünnschichtverkapselung angegeben werden.

Diese Aufgaben werden durch eine Dünnschichtverkapselung mit den Merkmalen des Patentanspruches 1, durch einen optoelektronischen Halbleiterkörper mit den Merkmalen des Patentanspruches 10 und ein Verfahren mit den Schritten des Patentanspruches 13 gelöst.

Vorteilhafte Weiterbildungen sowie Ausführungsformen sind in den abhängigen Ansprüchen angegeben.

Eine Dünnschichtverkapselung für einen optoelektronischen Halbleiterkörper umfasst insbesondere die folgenden Schichten:
- eine mittels eines PVD-Verfahrens abgeschiedene PVD-Schicht, und
- eine mittels eines CVD-Verfahrens abgeschiedene CVD-Schicht.

Bei einem PVD-Verfahren ("physical vapour deposition", physikalische Gasphasenabscheidung) wird die zu beschichtende Oberfläche in einem Volumen, beispielsweise in einem Rezipienten, zur Verfügung gestellt. In dem Volumen wird weiterhin ein Ausgangsmaterial in der Gasphase bereit gestellt. Das Ausgangsmaterial kondensiert direkt auf der Oberfläche und bildet so eine feste PVD-Schicht auf der Oberfläche aus.

Zu den PVD-Verfahren zählen insbesondere thermisches Verdampfen, bei dem das Ausgangsmaterial durch Temperaturbeaufschlagung in die Gasphase übergeführt wird, sowie Sputtern, bei dem das Ausgangsmaterial durch Ionenbeschuss in die Gasphase übergeführt wird. Weiterhin handelt es sich auch beim Elektronenstrahlverdampfen, bei dem das Ausgangmaterial mit Hilfe eines Elektronenstrahls in die Gasphase über geführt wird, um ein PVD-Verfahren. In der Regel zeigen PVD-Schichten typischerweise Korngrenzen, wobei der Diffusionskoeffizient der PVD-Schicht entlang den Korngrenzen in der Regel deutlich höher ist als im Volumenmaterial.

Bei einem CVD-Verfahren ("chemical vapour deposition"1, chemische Gasphasenabscheidung) wird ebenfalls die zu beschichtende Oberfläche in einem Volumen zur Verfügung gestellt. In dem Volumen wird weiterhin zumindest ein Ausgangsmaterial zur Verfügung gestellt, aus dem durch eine chemische Reaktion an der zu beschichtenden Oberfläche eine feste CVD-Schicht abgeschieden wird. In der Regel befindet sich in dem Volumen zumindest ein zweites Ausgangsmaterial, mit dem das erste Ausgangsmaterial unter Bildung der festen CVD-Schicht an der Oberfläche chemisch reagiert. Das CVD-Verfahren zeichnet sich somit durch mindestens eine chemische Reaktion an der zu beschichtenden Oberfläche zur Bildung der CVD-Schicht aus. In der Regel findet die chemische Reaktion bei einer bestimmten Reaktionstemperatur statt. Besonders bevorzugt weist die zu beschichtende Oberfläche die Reaktionstemperatur auf, bei der chemische Reaktion zur Bildung der festen CVD-Schicht stattfindet. Bei der chemischen Gasphasenabscheidung können auch mehr als zwei Ausgangsmaterialien zum Einsatz kommen.

Unter CVD-Verfahren sind vorliegend insbesondere die folgenden Verfahren verstanden: PECVD-Verfahren ("plasma enhanced chemical vapour deposition", plasmaunterstützte chemische Gasphasenabscheidung), MOCVD-Verfahren ("metal organic chemical vapour deposition" metallorganische chemische Gasphasenabscheidung), ALD-Verfahren ("atomic layer deposition", Atomlagenabscheidung) und NLD-Verfahren ("nano layer deposition", Nanoschichtabscheidung).

Bei einem PECVD-Verfahren wird in der Regel ein Plasma in dem Volumen bei der chemischen Abscheidung gezündet, während die chemische Abscheidung bei einem MOCVD-Verfahren unter Einsatz mindestens einer metallorganischen Ausgangsverbindung durchgeführt wird.

Mit Atomlagenabscheidung (atomic layer deposition, ALD) ist vorliegend ein CVD-Verfahren bezeichnet, bei dem das erste gasförmige Ausgangsmaterial dem Volumen zugeführt wird, in dem die zu beschichtende Oberfläche bereitgestellt ist, sodass das erste gasförmige Ausgangsmaterial auf der Oberfläche adsorbiert. Nach einer bevorzugt vollständigen oder nahezu vollständigen Bedeckung der Oberfläche mit einer Atom- bzw. Moleküllage des Ausgangsmaterials sättigt die Abscheidung und es wird kein weiteres Material mehr abgeschieden. Anschließend wird der Teil des ersten Ausgangsmaterial, der noch gasförmig bzw. nicht auf der Oberfläche adsorbiert vorliegt, in der Regel wieder aus dem Volumen entfernt und das zweite Ausgangsmaterial zugeführt. Das zweite Ausgangsmaterial ist dafür vorgesehen, mit der an der Oberfläche adsorbierten, ersten Ausgangsverbindung unter Bildung einer festen ALD-Schicht chemisch zu reagieren. Die beiden oben beschriebenen Prozessschritte werden so oft wiederholt, bis die gewünschte Dicke der ALD-Schicht erreicht ist.

Mit NLD-Verfahren wird vorliegend ein CVD-Verfahren bezeichnet, bei dem das Schichtwachstum der CVD-Schicht unterbrochen wird, nachdem ein vorgegebener Wert der Schichtdicke erreicht ist. Dieser vorgegebene Wert liegt bevorzugt zwischen 0,5 nm und 5 nm, wobei die Grenzen eingeschlossen sind. In einem weiteren Schritt wird die Schicht einer Plasmabehandlung ausgesetzt. In der Regel werden durch die Plasmabehandlung unvollständig abreagierte Reste des gasförmigen Ausgangsmaterials, die in der Regel organischer Natur sind, vorteilhafterweise entfernt. Dies beeinflusst die Schichteigenschaften in der Regel positiv. Die CVD-Abscheidung und die Plasmabehandlung werden so oft wiederholt, bis die gewünschte Schichtdicke der NLD-Schicht erreicht ist.

Im Unterschied zu dem ALD-Verfahren ist mit einem NLD-Verfahren die Abscheidung einer CVD-Schicht, deren Dicke eine Atomlage übersteigt, in einem Prozessschritt möglich.

Unter einem CVD-Verfahren soll vorliegend weiterhin insbesondere auch ein Verfahren verstanden werden, bei dem in dem Volumen neben der zu beschichtenden Oberfläche lediglich ein einziges gasförmiges Ausgangmaterial zur Verfügung gestellt wird, das zur Bildung der festen CVD-Schicht mit chemischen Gruppen der zu beschichtenden Oberfläche chemisch reagiert. Beispielsweise kann in dem Volumen gasförmiges Hexamethyldisilazan (HMDS) als Ausgangsmaterial zur Verfügung gestellt werden, das mit OH-Gruppen auf einer Oberfläche, beispielsweise einer Halbleiteroberfläche, eine feste HMDS-Schicht als CVD-Schicht bildet.

Strukturelle Schwachstellen an topografischen Unebenheiten können sich während des PVD-Verfahrens in einer PVD-Schicht beispielsweise durch einen schrägen Einfall des Ausgangsmaterials auf die zu beschichtende Oberfläche, durch Abschattung durch die sich bildende PVD-Schicht oder fehlende Oberflächenbeweglichkeit des abgeschiedenen Ausgangsmaterials bilden.

Eine zentrale Idee ist es, strukturelle Schwachstellen der PVD-Schicht, die insbesondere an topografischen Unebenheiten, der zu beschichtenden Oberfläche vorliegen können, mit Hilfe einer zweiten Schicht zu schließen. Die strukturellen Schwachstellen haben häufig ein hohes Aspektverhältnis. Wegen der hohen Überformung eignen sich zum Verschließen besonders CVD-Verfahren.

Die hier beschriebene Dünnschichtverkapselung ist mit Vorteil in der Regel hermetisch dicht gegenüber aggressiven Flüssigkeiten, wie sie beispielsweise bei nasschemischen Prozessen in der Halbleitertechnologie verwendet werden. Weiterhin ist die Dünnschichtverkapselung bevorzugt im Wesentlichen gasdicht und verhindert in der Regel die Diffusion von Atomen oder Ionen, beispielsweise Metallionen.

Besonders bevorzugt ist die hier beschriebene Dünnschichtverkapselung mit einer CVD-Schicht und einer PVD-Schicht dazu geeignet, Oberflächen mit Unebenheiten, die ein Aspektverhältnis größer als 20:1 aufweisen, hermetisch dicht gegenüber Umwelteinflüssen, insbesondere Flüssigkeiten, zu verkapseln. Die Dünnschichtverkapselung ist aber auch dazu geeignet, strukturierte Oberflächen mit kleineren Aspektverhältnissen zuverlässig zu verkapseln.

Die PVD-Schicht und die CVD-Schicht bilden eine gemeinsame Grenzfläche aus, das heißt, dass die PVD-Schicht und die CVD-Schicht sich in direktem Kontakt miteinander befinden.

Gemäß einer Ausführungsform der Dünnschichtverkapselung ist die PVD-Schicht-elektrisch leitend ausgebildet. Hierdurch ist es insbesondere möglich, eine elektrisch leitende Dünnschichtverkapselung zu erzeugen, über die ein zu verkapselnder Halbleiterkörper mit Vorteil elektrisch kontaktiert werden kann.

Die Dicke der PVD-Schicht liegt bevorzugt zwischen 50 nm und 400 nm, wobei die Grenzen eingeschlossen sind.

Gemäß einer Ausführungsform der Dünnschichtverkapselung weist die PVD-Schicht zumindest eines der folgenden Materialien auf oder besteht aus einem der folgenden Materialien: Titan, Wolfram, Titanwolfram, Titannitrid, Wolframnitrid, Titanwolframnitrid, Platin, Nickel, Gold, Tantal. Eine PVD-Schicht, die eines dieser Materialien aufweist oder aus einem dieser Materialien besteht, ist in der Regel elektrisch leitend ausgebildet.

Die Dicke der CVD-Schicht liegt bevorzugt zwischen 2 nm und 20 nm, wobei die Grenzen eingeschlossen sind.

Gemäß einer Ausführungsform weist die CVD-Schicht eines der folgenden Materialien auf oder besteht aus einem der folgenden Materialien: Silizium, Siliziumoxid, Siliziumnitrid, Titannitrid. Eine CVD-Schicht, die Silizium, Siliziumoxid oder Siliziumnitrid aufweist oder aus einem dieser Materialien besteht, ist in der Regel elektrisch isolierend ausgebildet.

Gemäß einer Ausführungsform der Dünnschichtverkapselung weist die CVD-Schicht ein elektrisch isolierendes Material auf oder besteht aus einem dieser Materialien. Elektrisch isolierende Materialien können mit Vorteil in der Regel deutlich kostengünstiger und mit geringerem operativem Aufwand mittels eines CVD-Verfahrens abgeschieden werden, als elektrisch leitende Materialien, wie beispielsweise Titannitrid.

Weiterhin ist es auch möglich, dass die Dünnschichtverkapselung aus mehreren alternierend angeordneten CVD-Schichten und PVD-Schichten aufgebaut ist. Hierbei ist es nicht notwendigerweise nötig, dass die PVD-Schichten und die CVD-Schichten dasselbe Material und/oder dieselbe Dicke aufweisen.

Die CVD-Schicht ist in direktem Kontakt auf die PVD-Schicht aufgebracht und die CVD-Schicht ist derart rückgeätzt, dass die CVD-Schicht lediglich strukturelle Schwachstellen in der PVD-Schicht ausfüllt. Auf diese Art und Weise kann vorteilhafterweise auch mit einer CVD-Schicht, die ein isolierendes Material aufweist, eine elektrisch leitfähige Dünnschichtverkapselung erzielt werden, wenn für die PVD-Schicht ein elektrisch leitfähiges Material verwendet ist.

Besonders bevorzugt befindet sich die PVD-Schicht in direktem Kontakt mit der Oberfläche des zu verkapselnden Halbleiterkörpers. Bevorzugt weist die Dünnschichtverkapselung weiterhin lediglich eine einzige CVD-Schicht und lediglich eine einzige PVD-Schicht auf. Besonders bevorzugt besteht die Dünnschichtverkapselung aus einer einzigen CVD-Schicht und einer einzigen PVD-Schicht.

Das Rückätzen der CVD-Schicht in der Fläche wird bevorzugt mit einem gerichteten Ätzverfahren, wie beispielsweise Rücksputtern, durchgeführt. Unter einem gerichteten Verfahren ist hierbei zu verstehen, dass das Ätzen auf gerichtete Art und Weise erfolgt, das bedeutet, Material wird anisotrop von der geätzten Oberfläche entfernt.

Das Rückätzen wird bevorzugt so durchgeführt, dass die CVD-Schicht auf den Teilen der beschichteten Oberfläche, die keine topographischen Unebenheiten und/oder Spalte aufweisen, wieder zuverlässig entfernt wird, wohingegen in den strukturellen Schwachstellen das Material der CVD-Schicht zurückbleibt. Vorteilhaft bei diesem Ansatz ist die große Auswahl an CVD-Materialien. Insbesondere könne so isolierende Materialien für die CVD-Schicht verwendet werden, wie zum Beispiel Siliziumnitrid, wobei trotzdem eine elektrisch leitende Dünnschichtverkapselung erzielt werden kann.

Gemäß einer weiteren Ausführungsform ist auf der rückgeätzten CVD-Schicht eine weitere PVD-Schicht angeordnet, die ebenfalls mittels eines PVD-Verfahrens abgeschieden ist.

Gemäß einer Ausführungsform ist die CVD-Schicht direkt auf dem zu beschichteten Halbleiterkörper abgeschieden. Über der CVD-Schicht ist die PVD-Schicht in direktem Kontakt mit der CVD-Schicht angeordnet. Die PVD-Schicht dient hierbei dazu, die CVD-Schicht vor mechanischen und/oder chemischen Angriffen zu schützen.

Die Dünnschichtverkapselung ist insbesondere für den Einsatz in einem optoelektronischen, bevorzugt strahlungsemittierenden Halbleiterkörper geeignet. Besonders bevorzugt verkapselt die Dünnschichtverkapselung ein metallisches Element des Halbleiterkörpers, wie etwa einen elektrischen Kontakt oder eine reflektierende Schicht gegenüber Umwelteinflüssen. Hierbei ist die Dünnschichtverkapselung in der Regel in den Halbleiterkörper integriert. Besonders bevorzugt ist die Dünnschichtverkapselung in direktem Kontakt auf das zu verkapselnde Element aufgebracht.

Weiterhin ist die Dünnschichtverkapselung dazu geeignet, geschliffene Oberflächen, wie beispielsweise geschliffene Wafer-Oberflächen dicht zu verkapseln, die in der Regel aufgrund von Schleifriefen stark zerklüftet sind.

Gemäß einer Ausführungsform des optoelektronischen Halbleiterkörpers weist das metallische Element mindestens eines der folgenden Materialien auf oder besteht aus mindestens einem der folgenden Materialien: Silber, Aluminium, Gold, Titan, Nickel.

Eine reflektierende metallische Schicht kann beispielsweise dazu vorgesehen sein, elektromagnetische Strahlung, die in einer aktiven Zone einer epitaktischen Halbleiterschichtenfolge des Halbleiterkörpers erzeugt wird, zu reflektieren.

Die Dicke der metallischen Schicht liegt bevorzugt zwischen 50 nm und 250 nm, wobei die Grenzen eingeschlossen sind.

Bevorzugt bedeckt die reflektierende metallische Schicht die epitaktische Halbleiterschichtenfolge nicht vollständig, sondern lässt seitlich zumindest Teilbereiche der epitaktischen Halbleiterschichtenfolge frei. Hierdurch entsteht auf der Oberfläche Halbleiterschichtenfolge - metallische Schicht eine Kante, die eine topographische Unebenheit darstellt.

Insbesondere die metallische Schicht ist empfindlich, beispielsweise für nasschemische Prozesse bei der Herstellung des Halbleiterkörpers. Hierzu muss die metallische Schicht zuverlässig zumindest gegen Flüssigkeiten verkapselt werden. Hierzu ist insbesondere eine Dünnschichtverkapselung geeignet, wie sie oben beschrieben wurde.

Bei dem optoelektronischen Halbleiterkörper kann es sich beispielsweise um eine Leuchtdiode handeln oder besonders bevorzugt um eine Dünnfilmleuchtdiode. Unter einer Dünnfilmleuchtdiode wird vorliegend eine Leuchtdiode verstanden, bei der das Wachstumssubstrat zum epitaktischen Aufwachsen der epitaktischen Halbleiterschichtenfolge von der epitaktischen Halbleiterschichtenfolge derart entfernt oder gedünnt ist, dass das Wachstumssubstrat alleine nicht mehr dazu geeignet ist, die epitaktische Halbleiterschichtenfolge mechanisch zu stabilisieren. Hierfür ist bei einer Dünnfilmleuchtdiode ein separat aufgebrachter Träger vorgesehen, der auf oder über der metallischen Schicht angeordnet ist.

Ein Verfahren zur Herstellung einer Dünnschichtverkapselung umfasst insbesondere die Schritte:
- Abscheiden einer PVD-Schicht mit einem PVD-Verfahren, und
- Abscheiden einer CVD-Schicht mit einem CVD-Verfahren, wobei
- die CVD-Schicht direkt auf der PVD-Schicht aufgebracht wird, und
- die CVD-Schicht derart rückgeätzt wird, dass die CVD-Schicht lediglich Schwachstellen in der PVD-Schicht auffüllt.

Im Übrigen können die oben in Zusammenhang mit einer Dünnschichtverkapselung beschriebenen Merkmale auch Teil des Herstellungsverfahrens sein.

Weitere vorteilhafte Ausführungsformen und Weiterbildungen der Erfindung ergeben sich aus dem im Folgenden in Verbindung mit den Figuren beschriebenen Ausführungsbeispiel.
Die Figuren 1A bis 1C zeigen schematische Schnittdarstellungen eines optoelektronischen Halbleiterkörpers während verschiedener Verfahrensstadien zur Herstellung einer Dünnschichtverkapselung.
Figur 2 zeigt eine schematische Schnittdarstellung eines optoelektronischen Halbleiterkörpers mit einer Dünnschichtverkapselung.
Figuren 3A, 3B und 3C zeigen schematische Schnittdarstellungen optoelektronischer Halbleiterkörper bei der Herstellung einer Dünnschichtverkapselung gemäß einem Ausführungsbeispiel während verschiedener Verfahrensstadien.
Figur 4 zeigt eine schematische Schnittdarstellung eines Halbleiterkörpers mit einer Dünnschichtverkapselung.
Figuren 5A, 5B und 5C zeigen schematische Schnittdarstellungen eines Halbleiterkörpers während Fertigungsschritten, in denen eine Dünnschichtverkapselung erzeugt wird.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente, insbesondere Schichtdicken zur besseren Darstellbarkeit und/oder zum besseren Verständnis übertrieben groß dargestellt sein.

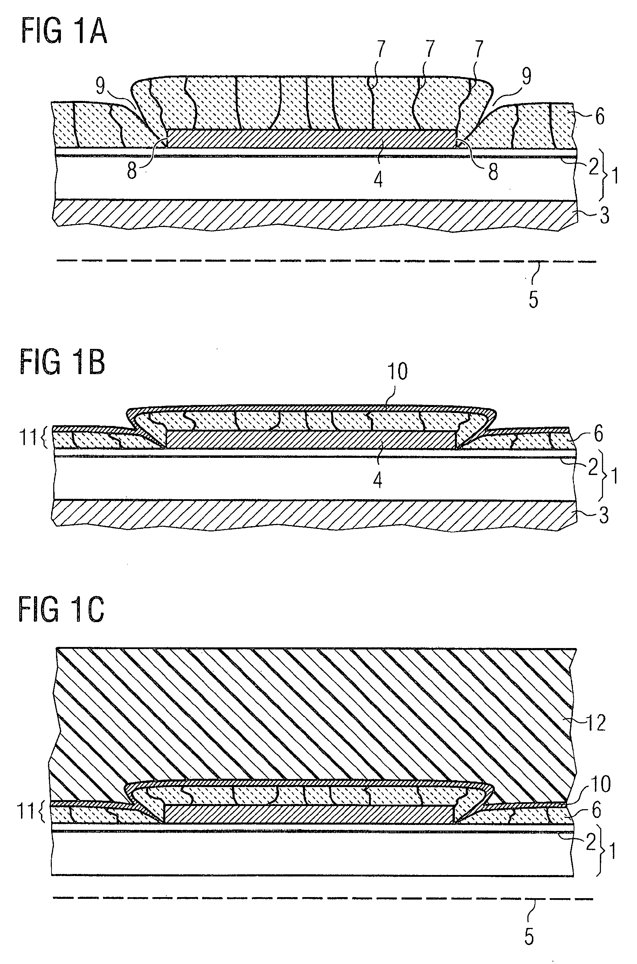

Der optoelektronische Halbleiterkörper gemäß der Figur 1A weist eine epitaktische Halbleiterschichtenfolge 1 mit einer aktiven Zone 2 zur Strahlungserzeugung auf.

Die aktive Zone 2 umfasst bevorzugt einen pn-Übergang, eine Doppelheterostruktur, einen Einfach-Quantentopf oder besonders bevorzugt eine Mehrfach-Quantentopfstruktur (MQW) zur Strahlungserzeugung. Die Bezeichnung Quantentopfstruktur beinhaltet hierbei keine Angabe über die Dimensionalität der Quantisierung. Sie umfasst somit u. a. Quantentröge, Quantendrähte und Quantenpunkte und jede Kombination dieser Strukturen.

Die epitaktische Halbleiterschichtenfolge 1 ist auf einem Wachstumssubstrat 3 epitaktisch gewachsen.

In direktem Kontakt auf die dem Wachstumssubstrat 3 gegenüberliegende Seite der epitaktischen Halbleiterschichtenfolge 1 ist eine metallische Schicht 4 als metallisches Element aufgebracht, die dazu geeignet ist, Strahlung der aktiven Zone 2 zu reflektieren. Die metallische Schicht 4 ist hierbei bevorzugt aus Silber gebildet oder weist Silber auf. Die Dicke der metallischen Schicht 4 liegt in der Regel zwischen 50 nm und 250 nm, wobei die Grenzen eingeschlossen sind. Die metallische Schicht 4 ist dazu vorgesehen, die Strahlung, die in der aktiven Zone 2 erzeugt wird zu einer strahlungsemittierenden Vorderseite 5 des Halbleiterkörpers zu reflektieren.

Die metallische Schicht 4 ist vorliegend nicht über die gesamte Oberfläche der epitaktischen Halbleiterschichtenfolge 1 aufgebracht, sondern bedeckt lediglich einen Teilbereich der Oberfläche der epitaktischen Halbleiterschichtenfolge 1. Seitlich der metallischen Schicht 4 sind jeweils Teilbereiche der Oberfläche der epitaktischen Halbleiterschichtenfolge 1 frei von der metallischen Schicht 4.

Auf der metallischen Schicht 4 und auf der seitlich freiliegenden Oberfläche der epitaktischen Halbleiterschichtenfolge 1 ist vorliegend eine PVD-Schicht 6 angeordnet, die mittels eines PVD-Verfahrens abgeschieden wurde. Die PVD-Schicht 6 steht in direktem Kontakt mit der metallischen Schicht 4 und mit der Oberfläche der epitaktischen Halbleiterschichtenfolge 1.

Die PVD-Schicht 6 weist bevorzugt eine Dicke zwischen 50 nm und 400 nm auf, wobei die Grenzen eingeschlossen sind. Die PVD-Schicht 6 ist vorliegend elektrisch leitend ausgebildet. Sie weist beispielsweise Titanwolframnitrid auf. Alternativ kann die PVD-Schicht 6 auch eines der folgenden Materialien aufweisen oder aus einem der folgenden Materialien bestehen: Titan, Wolfram, Titanwolfram, Titannitrid, Wolframnitrid, Titanwolframnitrid, Platin, Nickel, Gold, Tantal. Aufgrund ihres Herstellungsprozesses weist die PVD-Schicht 6 Korngrenzen 7 auf.

Aufgrund der Dicke der metallischen Schicht 4 ist jeweils eine Kante 8 in der Oberfläche des Halbleiterkörpers an dem Übergang von der metallischen Schicht 4 zur epitaktischen Halbleiterschichtenfolge 1 vorhanden. Aufgrund der topographischen Unebenheiten, die durch die beiden Kanten 8 gebildet werden, weist die PVD-Schicht 6 Spalte 9 an diesen Stellen auf.

Um die Spalte 9 innerhalb der PVD-Schicht 6 zu verfüllen, wird nun in einem nächsten Verfahrensschritt eine CVD-Schicht 10 mittels eines CVD-Verfahrens in direktem Kontakt auf die PVD-Schicht 6 abgeschieden (Figur 1B). Die PVD-Schicht 6 und die CVD-Schicht 10 bilden vorliegend eine Dünnschichtverkapselung 11 aus.

Soll eine elektrisch leitende Dünnschichtverkapselung 11 erzielt werden, beispielsweise um die epitaktische Halbleiterschichtenfolge 1 durch die Dünnschichtverkapselung 11 elektrisch kontaktieren zu können, so wird die CVD-Schicht 10 aus einem elektrisch leitenden Ausgangsmaterial, wie beispielsweise Titannitrid, gebildet. Die Dicke der CVD-Schicht 10 liegt bevorzugt zwischen 2 nm und 20 nm, wobei die Grenzen eingeschlossen sind. Die CVD-Schicht 10 verfüllt die Spalte 9 in der darunter liegenden PVD-Schicht 6 und dichtet auch die Korngrenzen 7 ab. Auf diese Art und Weise dichtet die Dünnschichtverkapselung 11 die empfindliche metallisches Schicht 4 zuverlässig insbesondere gegenüber Flüssigkeiten ab.

In einem weiteren Schritt wird ein Träger 12 auf oder über der Dünnschichtverkapselung 11 angeordnet und das Wachstumssubstrat 3 entfernt oder derart gedünnt, dass es die epitaktische Halbleiterschichtenfolge 1 alleine nicht mehr ausreichend mechanisch stabilisiert. Anstelle des Wachstumssubstrats 3 stabilisiert der Träger 12 die epitaktische Halbleiterschichtenfolge 1 mechanisch (Figur 1C).

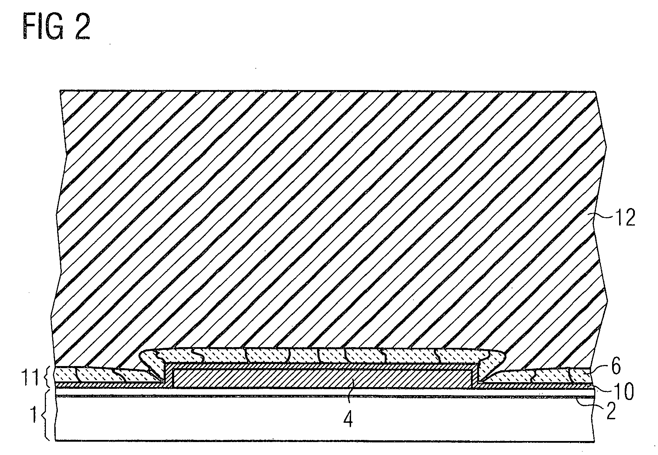

Der optoelektronische Halbleiterkörper gemäß der Figur 2 weist im Unterschied zu dem optoelektronischen Halbleiterkörper gemäß der Figur 1C eine Dünnschichtverkapselung 11 auf, bei der die CVD-Schicht 10 in direktem Kontakt mit der metallischen Schicht 4 steht.

Weiterhin ist die CVD-Schicht 10 auch seitlich der metallischen Schicht 4 auf der Oberfläche der epitaktischen Halbleiterschichtenfolge 1 angeordnet. In direktem Kontakt auf die CVD-Schicht 10 ist weiterhin eine PVD-Schicht 6 angeordnet. Die PVD-Schicht 6 dient hierbei dazu, die CVD-Schicht 10 vor mechanischen und chemischen Angriffen zu schützen.

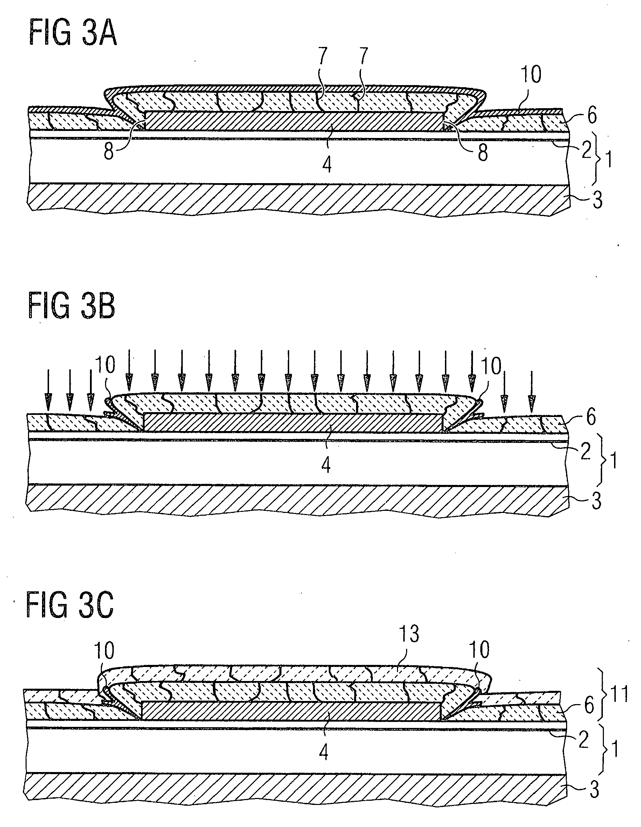

Bei dem optoelektronischen Halbleiterkörper gemäß dem Ausführungsbeispiel der Figur 3A ist die CVD-Schicht 10 im Unterschied zu dem Verfahrensstadium gemäß Figur 1B elektrisch isolierend ausgebildet. Hierzu umfasst die CVD-Schicht 10 bevorzugt Siliziumnitrid oder besteht aus Siliziumnitrid.

In einem nächsten Verfahrensschritt wird, wie in Figur 3B zu sehen, die elektrisch isolierende CVD-Schicht 10 mit einem gerichteten Verfahren, beispielsweise Sputtern, rückgeätzt.

Bei dem Rückätzen werden die Teile der Oberfläche der PVD-Schicht 6 vollständig freigelegt, die keine Schwachstellen aufgrund darunter liegender Kanten 8 aufweisen. Lediglich die Spalte 9 jeweils seitlich der metallischen Schicht 4, die aufgrund des Höhenunterschieds zwischen metallischer Schicht 4 und epitaktischer Halbleiterschichtenfolge 1 in der PVD-Schicht 6 entstanden sind, sind weiterhin mit dem Material der CVD-Schicht 10 hermetisch dicht verfüllt.

In einem weiteren Verfahrensschritt wird eine weitere PVD-Schicht 13 mittels eines PVD-Verfahrens abgeschieden (Figur 3C). Diese weitere PVD-Schicht 13 befindet sich auf den freien Oberflächen der ersten PVD-Schicht 6 in direktem Kontakt mit dieser. Die weitere PVD-Schicht 13 kann beispielsweise wie die erste PVD-Schicht 6 ausgestaltet sein.

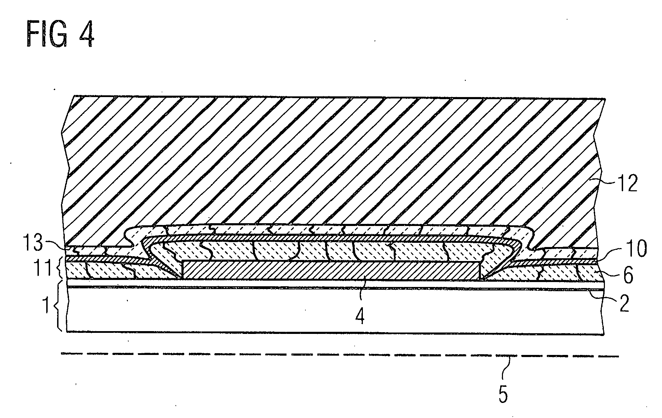

Die Dünnschichtverkapselung 11 bei dem Halbleiterkörper gemäß der Figur 4 weist eine PVD-Schicht 6 auf, die in direktem Kontakt auf die metallische Schicht 4 mittels eines PVD-Verfahren abgeschieden wurde. Die PVD-Schicht 6 weist beispielsweise eine Dicke von ca. 100 nm auf und ist aus Titanwolframnitrid gebildet. In direktem Kontakt auf die PVD-Schicht 6 ist eine CVD-Schicht 10 mittels eines CVD-Verfahrens abgeschieden. Die CVD-Schicht 10 weist beispielsweise eine Dicke von ca. 10 nm auf und ist aus Titannitrid gebildet. In direktem Kontakt auf die CVD-Schicht 10 ist eine weitere PVD-Schicht 13 mittels eines PVD-Verfahrens abgeschieden. Die weitere PVD-Schicht 13 ist hierbei ausgestaltet, wie die erste PVD-Schicht 6. Alternativ ist es auch möglich, dass sich die weitere PVD-Schicht 13 von der PVD-Schicht 6 hinsichtlich Materialzusammensetzung und/oder Dicke unterscheidet. Die Dünnschichtverkapselung 11 ist vorliegenden durch die erste PVD-Schicht 6, die CVD-Schicht 10 und die weitere PVD-Schicht 13 gebildet. Da die erste PVD-Schicht 6, die CVD-Schicht 10 und die weitere PVD-Schicht 13 aus elektrisch leitenden Materialien gebildet sind, ist auch die Dünnschichtverkapselung 11 elektrisch leitend ausgebildet.

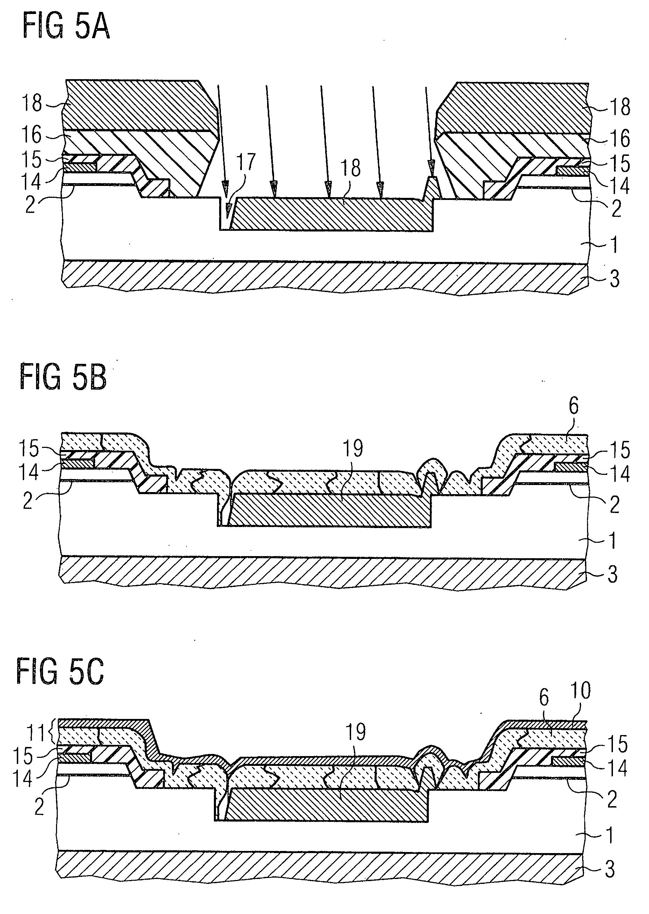

Der optoelektronische Halbleiterkörper, der bei dem Verfahren gemäß den Figuren 5A bis 5C hergestellt wird, umfasst eine Halbleiterschichtenfolge 1 mit einer aktiven Zone 2, die dazu geeignet ist, elektromagnetische Strahlung zu erzeugen. Die Halbleiterschichtenfolge 1 ist auf einem Aufwachssubstrat 3 epitaktisch aufgewachsen. Die Halbleiterschichtenfolge 1 weist eine stufenförmige Ausnehmung auf, die die aktive Zone 2 durchdringt und die in einem vorangegangenen Verfahrensschritt erzeugt wurde, beispielsweise durch Trockenätzen.

Seitlich der stufenförmigen Ausnehmung ist auf die Halbleiterschichtenfolge 1 ein erster elektrischer Kontakt 14 angeordnet, der auch umlaufend um den gesamten Halbleiterkörper angeordnet sein kann. Bei dem ersten elektrischen Kontakt 14 kann es sich beispielsweise um einen p-Kontakt handeln. Auf dem p-Kontakt ist weiterhin eine isolierende Schicht 15 aufgebracht, die beispielsweise Siliziumoxid umfasst oder aus Siliziumoxid gebildet ist. Auf der isolierenden Schicht 15 ist eine Fotolackschicht 16 aufgebracht, die eine zentrale Vertiefung 17 der stufenförmigen Ausnehmung frei lässt.

In der zentralen Vertiefung 17 der stufenförmigen Ausnehmung wird während des Verfahrensschritts der Figur 5A ein metallisches Material 18 zur Bildung eines zweiten elektrischen Kontaktes 19, beispielsweise eines n-Kontaktes, abgeschieden. Die Abscheidung des metallischen Materials 18 kann beispielsweise durch Elektronenstrahlverdampfen oder thermisches Verdampfen erfolgen. Wie in Figur 5A durch die Pfeile angedeutet, kann der Materialauftrag hierbei leicht schräg erfolgen. Dadurch entsteht an der einen Seitenfläche der zentralen Vertiefung 17 ein Bereich, der frei von metallischem Material 18 ist, während sich an der anderen Seitenfläche ein Überschuss an Material ansammelt. Auf diese Art und Weise bilden sich an den Seitenflächen der zentralen Vertiefung 17 topographische Unebenheiten aus.

Der zweite elektrische Kontakt 19, der durch die Abscheidung des metallischen Materials 18 in der zentralen Vertiefung 17 gebildet wird, stellt ein metallisches Element dar, das beispielsweise eines der folgenden Materialien aufweist oder aus einem der folgenden Materialien besteht: Silber, Aluminium, Gold, Titan, Nickel.

In einem nächsten nicht dargestellten Verfahrensschritt wird die Fotolackschicht 16 entfernt.

In einem weiteren Verfahrensschritt wird zur Verkapselung des zweiten elektrischen Kontaktes 19 eine PVD-Schicht 6 über dem Halbleiterkörper abgeschieden, wie in Figur 5B gezeigt. Die PVD-Schicht 6 wird in direktem Kontakt auf den zweiten metallischen Kontakt angeordnet. An den topographischen Unebenheiten können sich Schwachstellen in der PVD-Schicht 6 ausbilden.

In einem weiteren Verfahrensschritt, der in Figur 5C dargestellt ist, wird daher in direktem Kontakt auf die PVD-Schicht 6 eine CVD-Schicht 10 abgeschieden, die vorhandene Schwachstellen hermetisch verschließt. Vorliegend ist die Dünnschichtverkapselung 11 aus der PVD-Schicht 6 und der CVD-Schicht 10 elektrisch leitend ausgebildet, so dass die aktive Zone 2 durch die Dünnschichtverkapselung 11 elektrisch kontaktiert werden kann.

In einem weiteren Verfahrensschritt, der vorliegend nicht dargestellt ist, wird rückseitig über die CVD-Schicht 10 in der Regel ein Träger, beispielsweise aus Germanium oder Silizium, aufgebracht. Der Träger wird in der Regel mit einem geeigneten Lot mit der CVD-Schicht 10 verbunden. Anschließend wird das Aufwachssubstrat 3 von der epitaktischen Halbleiterschichtenfolge 1 entfernt. Die dadurch freigelegt Seite des Halbleiterkörpers ist in der Regel als Strahlungsaustrittsfläche vorgesehen.

Die vorliegende Anmeldung beansprucht die Priorität der deutschen Anmeldung DE 10 2010 044 738.2.

Die Erfindung ist nicht durch die Beschreibung anhand des Ausführungsbeispiel auf dieses beschränkt, sondern wird durch die beigefügten Ansprüche definiert.

## Patentansprüche

1. Dünnschichtverkapselung (11) für einen optoelektronischen Halbleiterkörper mit:
- einer mittels eines PVD-Verfahrens abgeschiedenen PVD-Schicht (6), und
- einer mittels eines CVD-Verfahrens abgeschiedenen CVD-Schicht (10), **dadurch gekennzeichnet, dass**
- die CVD-Schicht (10) direkt auf der PVD-Schicht (6) aufgebracht ist, und
- die CVD-Schicht (10) derart rückgeätzt ist, dass die CVD-Schicht (10) lediglich Schwachstellen in der PVD-Schicht (6) auffüllt.

2. Dünnschichtverkapselung (11) nach dem vorherigen Anspruch, bei der die PVD-Schicht (6) elektrisch leitend ausgebildet ist.

3. Dünnschichtverkapselung (11) nach einem der obigen Ansprüche, bei der die Dicke der PVD-Schicht (6) zwischen 50 nm und 400 nm liegt, wobei die Grenzen eingeschlossen sind.

4. Dünnschichtverkapselung (11) nach einem der obigen Ansprüche, bei der die PVD-Schicht (6) eines der folgenden Materialien aufweist: Titan, Wolfram, Titanwolfram, Titannitrid, Wolframnitrid, Titanwolframnitrid, Platin, Nickel, Gold, Tantal.

5. Dünnschichtverkapselung (11) nach einem der obigen Ansprüche, bei der die Dicke der CVD-Schicht (10) zwischen 2 nm und 20 nm liegt, wobei die Grenzen eingeschlossen sind.

6. Dünnschichtverkapselung (11) nach einem der obigen Ansprüche, bei der die CVD-Schicht (10) eines der folgenden Materialien aufweist: Silizium, Siliziumoxid, Siliziumnitrid, Titannitrid.

7. Dünnschichtverkapselung (11) nach einem der obigen Ansprüche, die mehrere alternierend angeordnete CVD-Schichten (10) und PVD-Schichten (6, 13) aufweist.

8. Dünnschichtverkapselung (11) nach einem der obigen Ansprüche, bei der auf der rückgeätzten CVD-Schicht (10) eine weitere mittels eines PVD-Verfahrens abgeschiedene PVD-Schicht (13) angeordnet ist.

9. Dünnschichtverkapselung (11) nach einem der obigen Ansprüche, bei der die CVD-Schicht (10) ein elektrisch isolierendes Material aufweist.

10. Optoelektronischer Halbleiterkörper mit einer Dünnschichtverkapselung (11) nach einem der obigen Ansprüche, die ein metallisches Element des Halbleiterkörpers verkapselt.

11. Optoelektronischer Halbleiterkörper nach dem vorherigen Anspruch, bei dem das metallische Element ein elektrischer Kontakt oder eine reflektierende Schicht (4) ist.

12. Optoelektronischer Halbleiterkörper nach einem der Ansprüche 10 bis 11, bei dem das metallische Element eines der folgenden Materialien aufweist: Silber, Aluminium, Gold, Titan, Nickel.

13. Verfahren zur Herstellung einer Dünnschichtverkapselung (11) mit den Schritten:
- Abscheiden einer PVD-Schicht (6) mit einem PVD-Verfahren, und
- Abscheiden einer CVD-Schicht (10) mit einem CVD-Verfahren, wobei
- die CVD-Schicht (10) direkt auf der PVD-Schicht (6) aufgebracht wird, und
- die CVD-Schicht (10) derart rückgeätzt wird, dass die CVD-Schicht (10) lediglich Schwachstellen in der PVD-Schicht (6) auffüllt.

14. Verfahren nach dem vorherigen Anspruch, bei der auf der rückgeätzten CVD-Schicht (10) eine weitere mittels eines PVD-Verfahrens abgeschiedene PVD-Schicht (13) angeordnet wird.

15. Verfahren nach einem der Ansprüche 13 bis 14, bei der die CVD-Schicht (10) ein elektrisch isolierendes Material aufweist.

16. Verfahren nach einem der Ansprüche 13 bis 15, bei der die PVD-Schicht (6) eines der folgenden Materialien aufweist: Titan, Wolfram, Titanwolfram, Titannitrid, Wolframnitrid, Titanwolframnitrid, Platin, Nickel, Gold, Tantal.

17. Verfahren nach einem der Ansprüche 13 bis 16, bei der die CVD-Schicht (10) eines der folgenden Materialien aufweist: Silizium, Siliziumoxid, Siliziumnitrid, Titannitrid.

## Claims

1. Thin-film encapsulation (11) for an optoelectronic semiconductor body comprising:
- a PVD layer (6) deposited by means of a PVD method, and
- a CVD layer (10) deposited by means of a CVD method, **characterized in that**
- the CVD layer (10) is applied directly on the PVD layer (6), and
- the CVD layer (10) is etched back in such a way that the CVD layer (10) only fills weak points in the PVD layer (6).

2. Thin-film encapsulation (11) according to the preceding claim, wherein the PVD layer (6) is embodied in an electrically conducting fashion.

3. Thin-film encapsulation (11) according to any of the preceding claims, wherein the thickness of the PVD layer (6) is between 50 nm and 400 nm, inclusive of the limits.

4. Thin-film encapsulation (11) according to any of the preceding claims, wherein the PVD layer (6) comprises one of the following materials: titanium, tungsten, titanium-tungsten, titanium nitride, tungsten nitride, titanium-tungsten nitride, platinum, nickel, gold, tantalum.

5. Thin-film encapsulation (11) according to any of the preceding claims, wherein the thickness of the CVD layer (10) is between 2 nm and 20 nm, inclusive of the limits.

6. Thin-film encapsulation (11) according to any of the preceding claims, wherein the CVD layer (10) comprises one of the following materials: silicon, silicon oxide, silicon nitride, titanium nitride.

7. Thin-film encapsulation (11) according to any of the preceding claims, which comprises a plurality of CVD layers (10) and PVD layers (6, 13) arranged alternately.

8. Thin-film encapsulation (11) according to any of the preceding claims, wherein a further PVD layer (13) deposited by means of a PVD method is arranged on the etched-back CVD layer (10).

9. Thin-film encapsulation (11) according to any of the preceding claims, wherein the CVD layer (10) comprises an electrically insulating material.

10. Optoelectronic semiconductor body comprising a thin-film encapsulation (11) according to any of the preceding claims, which encapsulates a metallic element of the semiconductor body.

11. Optoelectronic semiconductor body according to the preceding claim, wherein the metallic element is an electrical contact or a reflective layer (4).

12. Optoelectronic semiconductor body according to either of Claims 10 and 11, wherein the metallic element comprises one of the following materials: silver, aluminum, gold, titanium, nickel.

13. Method for producing a thin-film encapsulation (11) comprising the following steps:
- depositing a PVD layer (6) by means of a PVD method, and
- depositing a CVD layer (10) by means of a CVD method, wherein
- the CVD layer (10) is applied directly on the PVD layer (6), and
- the CVD layer (10) is etched back in such a way that the CVD layer (10) only fills weak points in the PVD layer (6).

14. Method according to the preceding claim, wherein a further PVD layer (13) deposited by means of a PVD method is arranged on the etched-back CVD layer (10).

15. Method according to either of Claims 13 and 14, wherein the CVD layer (10) comprises an electrically insulating material.

16. Method according to any of Claims 13 to 15, wherein the PVD layer (6) comprises one of the following materials: titanium, tungsten, titanium-tungsten, titanium nitride, tungsten nitride, titanium-tungsten nitride, platinum, nickel, gold, tantalum.

17. Method according to any of Claims 13 to 16, wherein the CVD layer (10) comprises one of the following materials: silicon, silicon oxide, silicon nitride, titanium nitride.

## Revendications

1. Encapsulation en couches minces (11) pour un corps semi-conducteur optoélectronique, comprenant :
- une couche PVD (6) déposée par un procédé PVD et
- une couche CVD (10) déposée par un procédé CVD, **caractérisée en ce que**
- la couche CVD (10) est appliquée directement sur la couche PVD (6) et
- la couche CVD (10) est décapée de sorte que la couche CVD (10) ne remplisse que des points faibles dans la couche PVD (6).

2. Encapsulation en couches minces (11) selon la revendication précédente, dans laquelle la couche PVD (6) est configurée sous forme électriquement conductrice.

3. Encapsulation en couches minces (11) selon l'une quelconque des revendications précédentes, dans laquelle l'épaisseur de la couche PVD (6) est comprise entre 50 nm et 400 nm, les limites étant incluses.

4. Encapsulation en couches minces (11) selon l'une quelconque des revendications précédentes, dans laquelle la couche PVD (6) comprend un des matériaux suivants : titane, tungstène, titane-tungstène, nitrure de titane, nitrure de tungstène, nitrure de titane-tungstène, platine, nickel, or, tantale.

5. Encapsulation en couches minces (11) selon l'une quelconque des revendications précédentes, dans laquelle l'épaisseur de la couche CVD (10) est comprise entre 2 nm et 20 nm, les limites étant incluses.

6. Encapsulation en couches minces (11) selon l'une quelconque des revendications précédentes, dans laquelle la couche CVD (10) comprend un des matériaux suivantes : silicium, oxyde de silicium, nitrure de silicium, nitrure de titane.

7. Encapsulation en couches minces (11) selon l'une quelconque des revendications précédentes, qui comprend plusieurs couches CVD (10) et couches PVD (6, 13) agencées en alternance.

8. Encapsulation en couches minces (11) selon l'une quelconque des revendications précédentes, dans laquelle une couche PVD (13) supplémentaire déposée par un procédé PVD est agencée sur la couche CVD (10) décapée.

9. Encapsulation en couches minces (11) selon l'une quelconque des revendications précédentes, dans laquelle la couche CVD (10) comprend un matériau électriquement isolant.

10. Corps semi-conducteur optoélectronique comprenant une encapsulation en couches minces (11) selon l'une quelconque des revendications précédentes, qui encapsule un élément métallique du corps semi-conducteur.

11. Corps semi-conducteur optoélectronique selon la revendication précédente, dans lequel l'élément métallique est un contact électrique ou une couche réfléchissante (4).

12. Corps semi-conducteur optoélectronique selon l'une quelconque des revendications 10 à 11, dans lequel l'élément métallique comprend un des matériaux suivants : argent, aluminium, or, titane, nickel.

13. Procédé de fabrication d'une encapsulation en couches minces (11) comprenant les étapes suivantes :
- le dépôt d'une couche PVD (6) avec un procédé PVD et
- le dépôt d'une couche CVD (10) avec un procédé CVD,
- la couche CVD (10) étant appliquée directement sur la couche PVD (6) et
- la couche CVD (10) étant décapée de sorte que la couche CVD (10) ne remplisse que des points faibles dans la couche PVD (6).

14. Procédé selon la revendication précédente, dans lequel une couche PVD (13) supplémentaire déposée par un procédé PVD est agencée sur la couche CVD (10) décapée.

15. Procédé selon l'une quelconque des revendications 13 à 14, dans lequel la couche CVD (10) comprend un matériau électriquement isolant.

16. Procédé selon l'une quelconque des revendications 13 à 15, dans lequel la couche PVD (6) comprend un des matériaux suivants : titane, tungstène, titane-tungstène, nitrure de titane, nitrure de tungstène, nitrure de titane-tungstène, platine, nickel, or, tantale.

17. Procédé selon l'une quelconque des revendications 13 à 16, dans lequel la couche CVD (10) comprend un des matériaux suivants : silicium, oxyde de silicium, nitrure de silicium, nitrure de titane.
